# EUROPEAN PATENT SPECIFICATION

(11) **EP 3 743 280 B1**
(45) Date of publication and mention of the grant of the patent: **05.01.2022**
(21) Application number: 19706314.2
(22) Date of filing: 24.01.2019
(51) Int. Cl.: B22F 12/53, B33Y 40/00, B22F 10/22, B33Y 30/00, B05B 1/08, B41J 2/04, H05K 3/10

(54) **HEAD FOR THE THREE-DIMENSIONAL PRINTING OF MOLTEN METAL**
KOPF ZUM DREIDIMENSIONALEN DRUCKEN VON METALLSCHMELZE
TÊTE POUR L'IMPRESSION EN TROIS DIMENSIONS DE MÉTAL EN FUSION

(30) Priority: 26.01.2018 IT 201800002053
(43) Date of publication of application: 02.12.2020
(73) Proprietor: Graf S.p.A., 41015 Nonantola (MO) (IT)
(72) Inventor: VACCARI, Andrea, 41015 Nonantola (MO) (IT)
(74) Representative: Luppi, Emanuele
(86) International application number: PCT/IB2019/050591
(87) International publication number: WO 2019/145885

(56) References cited:
- WO-A1-2016/010448
- CN-A- 103 056 375
- JP-A- 2016 516 896
- US-A- 6 149 072
- US-A1- 2003 098 342
- US-A1- 2017 087 632
- US-A1- 2017 216 918

## Description

### Technical Field

The present invention relates to a head for the three-dimensional printing of molten metal.

### Background Art

The use is known of heads for the three-dimensional printing which are assembled on special printing equipment. These heads allow the creation of three-dimensional objects of various shapes without the use of molds.

The materials used for the three-dimensional printing are many, even if in most cases three-dimensional printers use polymeric materials that are dispensed in the molten state by means of the special head according to a three-dimensional digital model designed to make the object of interest.

However, production needs require the use of materials other than polymers, such as metals, and consequently in recent years, appliances for three-dimensional printing, designed for the use of metals, have become more widespread.

In particular, such appliances are equipped with specific heads which allow the molten metal to be dispensed on a support surface following the pre-established digital model.

An example of a head for the three-dimensional printing of molten metal is discussed in U.S. Patent No. US9616494, which shows a printing head including a containment chamber containing a liquid conductive material surrounded by an electromagnetic coil.

This electromagnetic coil is electrified, determining a radial force on the conductive material directed towards the inside of the chamber.

The force applied causes the ejection of a drop from an orifice and, in response to a series of pulses, a number of drops are ejected according to a programmed model, resulting in the formation of an object.

Digital printing metal heads of this type do have, however, a number of drawbacks.

The major drawback is related to the construction complexity of the known heads.

Actually, the heads described above are characterized by considerable construction complexity as they are made by assembling various components that cooperate synergistically with each other for the dispensing of the molten metal.

However, the complexity of the construction negatively affects the time needed for assembly and routine maintenance, with a corresponding increase in costs. Furthermore, the construction and operating complexity of the heads for molten metal described above entails a higher risk of faults, with the consequent need to provide for special maintenance or the replacement of the head.

Moreover, the operating temperatures are very high as they must necessarily be higher than the melting temperature of the metal used, so it is necessary to use various gaskets and sealing means made of materials particularly resistant to high temperatures.

However, the deterioration of the gaskets is rapid and this leads to their frequent replacement, with the need to dismantle and reassemble the head, which increases the time and costs of maintenance operations.

Again, the heads of known type do not permit the control and dispensing of low flow rates, so the accuracy of the molten metal deposition is limited.

Heads of the known type for the three-dimensional printing of molten metal are described in WO2016/010448A1, US2003/098342A1 and US2017/216918A1.

### Description of the Invention

The main aim of the present invention is to provide a head for the three-dimensional printing of molten metal with a simple structure.

Within the illustrated aim, one object of the present invention is to obtain a head for the three-dimensional printing of molten metal which permits reducing the incidence of faults compared to the heads of known type and, consequently, the costs for special maintenance associated with them.

Furthermore, one object of the present invention is to make a head for three-dimensional printing which permits reducing the costs associated with the assembly and the routine maintenance of the printer on which it is assembled. Another object of the present invention is to obtain a head for the three-dimensional printing of molten metal which allows making three-dimensional objects with high definition and accuracy.

Another object of the present invention is to provide a head for the three-dimensional printing of molten metal, which allows overcoming the aforementioned drawbacks of the prior art within the scope of a simple, rational, easy, efficient to use and cost-effective solution.

The aforementioned objects are achieved by the present head for the three-dimensional printing of molten metal according to claim 1.

### Brief Description of the Drawings

Other characteristics and advantages of the present invention will become more evident from the description of a preferred, but not exclusive embodiment of a head for the three-dimensional printing of molten metal, illustrated by way of an indicative, yet non-limiting example, in the attached drawings in which:

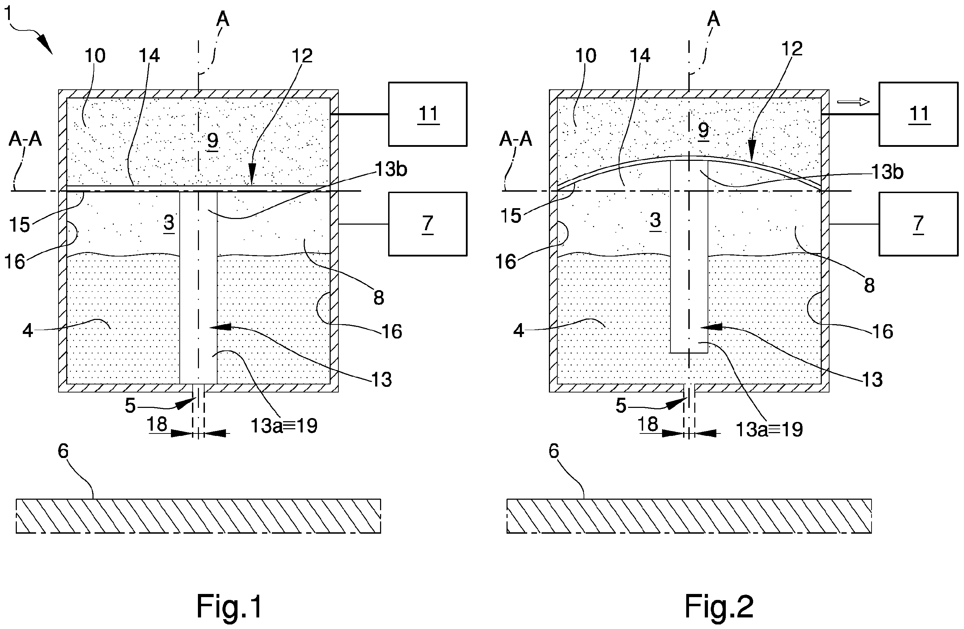

Figure 1 is a schematic sectional view of the head according to the invention in a home configuration;
Figure 2 is a schematic sectional view of the head according to the invention in a first configuration;

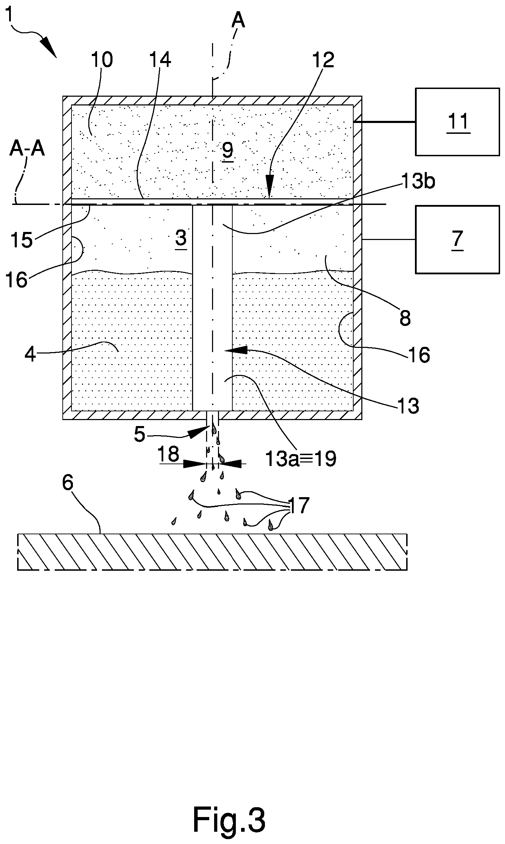

Figure 3 is a schematic sectional view of the head according to the invention in a second configuration.

### Embodiments of the Invention

With particular reference to these illustrations, reference numeral 1 globally indicates a head for the three-dimensional printing of molten metal.

The head 1 for the three-dimensional printing of molten metal comprises at least one hollow body 2 comprising at least a first chamber 3 adapted to contain at least one molten metal 4 in which at least one dispensing opening 5 is formed for the dispensing of the molten metal itself.

This head 1 is adapted to be assembled on at least one appliance for three-dimensional printing, not shown in the illustrations, for the distribution of molten metal 4 on at least one support 6 following a three-dimensional digital model, so as to make a three-dimensional object or a portion thereof.

In the preferred embodiment shown in the illustrations, the head 1 comprises melting means 7 adapted to produce the molten metal 4 from metal in the solid state by heating, connected by at least one adduction duct to the first chamber 3, so as to convey to it the molten metal itself.

The possibility of the solid metal being melted inside the first chamber 3 by means of specific melting means 7 integrated in the body 2 of the head 1 cannot however be ruled out.

Preferably, the molten metal 4 contained inside the first chamber 3 is aluminum, which is used to manufacture numerous products, despite the possibility not being ruled out of using a different type of molten metal or an alloy.

Usefully, the first chamber 3 is provided with heating means, for simplicity sake not shown in the illustrations, adapted to maintain the temperature of the molten metal 4 substantially equal to a predetermined value.

In particular, the temperature inside the first chamber 3 must be higher than the melting temperature of the metal used, which in the case of aluminum is equal to about 660°C, in order to keep it in the molten state and prevent its solidification inside the head 1 before dispensing.

In a preferred embodiment of the invention, the heating means used comprise at least one electrical heating element associated with the body 2 and adapted to heat the first chamber 3 and the molten metal 4 contained in it.

However, the use of different types of heating equipment cannot be ruled out, such as, e.g., the use of a lining placed outside the body 2 and inside which a heating fluid is conveyed, such as, e.g., super-saturated steam, compatible with the required operating temperatures.

Considering the high temperatures required, the body 2 is made of a material which is resistant to high temperatures, such as, e.g., special steel. Advantageously, the first chamber 3 contains inert atmosphere 8 in contact with the molten metal 4 and which occupies the free volume of the first chamber itself.

It should be pointed out that, within the scope of the present treatise, "inert atmosphere" means an atmosphere which does not chemically react with the molten metal 4 or which in any case reacts in a negligible way, so it does not alter its chemical-physical properties.

Preferably, in the particular case in which the molten metal 4 is aluminum, the inert atmosphere 8 is composed of at least one of argon and nitrogen, as aluminum tends to oxidize easily in the presence of oxygen in the air, with consequent irreversible modification of the chemical-physical characteristics, despite the possibility not being ruled out of providing for a component of the inert atmosphere 8 of a different type.

Still according to the invention, the body 2 of the head 1 comprises at least a second chamber 9 adapted to contain at least one operating fluid 10 and connected to pressure variation means 11 adapted to define a pressure difference between the first chamber 3 and the second chamber 9.

Preferably, the operating fluid 10 is air, although the possibility of using a different operating fluid 10, such as a liquid, cannot be ruled out.

Furthermore, the type of pressure variation means 11 used depends on the type of operating fluid 10 provided for, so as to correctly change the pressure inside the second chamber 9 with respect to the pressure in the first chamber 3. Preferably, if the operating fluid 10 is air, the pressure variation means 11 comprise at least one of a vacuum pump and a compressor, although the possibility of providing pressure variation means 11 of a different type cannot be ruled out.

In particular, in the event of the pressure of the operating fluid 10 having to be reduced to sub-atmospheric values, it is advisable to provide a vacuum pump, while if such pressure values are higher than the atmospheric values, the use of a compressor is useful.

In the preferred embodiment, the pressure variation means 11 comprise a vacuum pump.

Furthermore, the pressure difference defined between the first chamber 3 and the second chamber 9 can be positive, i.e. the pressure inside the second chamber 9 is lower than the pressure inside the first chamber 3, or negative, i.e. the pressure inside the second chamber 9 is higher than the pressure inside the first chamber 3.

Preferably, the pressure difference defined between the chambers 3, 9 is positive, although the possibility of providing a negative pressure difference cannot be ruled out.

Furthermore, according to the invention, the body 2 of the head 1 comprises at least one dispensing assembly 12, 13 comprising at least one flexible laminar element 12 separating the first chamber 3 and the second chamber 9.

According to the invention, the laminar element 12 is deformable by means of a pressure variation in the second chamber 9 and the deformation of the laminar element 12 determines the outflow of the molten metal 4 from the dispensing opening 5. Advantageously, the laminar element 12 comprises at least a first face 14 facing the first chamber 3 and at least a second face 15 opposite the first face 14 and facing the second chamber 9 and is peripherally associated in an irremovable manner with at least one lateral wall 16 of the body 2 by means of welding means.

Usefully, the fact of providing the laminar element 12 associated with the lateral wall 16 by means of welding means permits not having the need to provide gaskets or other sealing means, which are unlikely to withstand the required operating temperatures.

Furthermore, the first chamber 3 and the second chamber 9 are insulated from each other in a fluid-operated manner thanks to the presence of the laminar element 12, in order to ensure the pressure difference between the two chambers 3, 9 and to ensure that the operating fluid 10 and the inert atmosphere 8 do not come into contact with each other.

As mentioned above, the operating temperatures of the head 1 are high, so it is not possible to proceed with the assembly of the body 2 by interposition of rubber gaskets, inasmuch as these would not adequately resist the high temperatures.

Preferably, therefore, the body 2 is made in a single body piece, by means of at least two portions which are assembled together and welded, after the assembly of the dispensing assembly 12, 13, to obtain a single block which does not require gaskets or other sealing means.

Still according to the invention, the dispensing assembly 12, 13 comprises at least one dispensing element 13 housed in the first chamber 3, associated with the laminar element 12 and comprising at least one thrust portion 19 dipped in the molten metal 4 and arranged in the proximity of the dispensing opening 5. The deformation of the laminar element 12 occurs between a first configuration in which the thrust portion 19 is arranged away from the dispensing opening 5 and a second configuration in which the thrust portion 19 is approached to the dispensing opening 5.

According to the invention, the approach of the thrust portion 19 to the dispensing opening 5 determines the outflow of the molten metal 4 from the dispensing opening itself. In fact, the molten metal 4 contained inside the first chamber 3 has a very high viscosity, so it is not possible to dispense molten metal through the dispensing opening 5 by effect of weight force alone, but it is necessary to apply a force that pushes the molten metal 4 to flow out of the head 1.

Consequently, the deformation of the dispensing assembly 12, 13 allows a thrust to be applied to the molten metal 4 by means of the thrust portion 19, so that it is pushed through the dispensing opening 5 and allowed to come out.

In the preferred embodiment, in the second configuration the thrust portion 19 is arranged so as to close the dispensing opening 5, although the possibility cannot be ruled out of providing for the thrust portion itself in the second configuration remaining detached from the dispensing opening itself.

In other words, in the embodiment shown in the illustrations, during the movement between the described configurations, the thrust portion 19 abuts against the dispensing opening 5.

In other words, the pressure variation inside the second chamber 9 compared to the first chamber 3 causes a deformation of the laminar element 12, which, being flexible, changes its conformation, thus dragging the dispensing element 13 associated with it.

Furthermore, the displacement of the dispensing element 13 involves the consequent movement of the thrust portion 19, which, in moving alternately between the first configuration and the second configuration, pushes the thin layer of molten metal 4 located in the proximity of the dispensing opening 5 out through the same dispensing opening.

As described above, in the preferred embodiment, the pressure variation inside the second chamber 9 occurs by pressure reduction, although the possibility cannot be ruled out of providing for an increase in the pressure inside the second chamber itself.

In the preferred embodiment shown in the illustrations, in the second configuration the laminar element 12 is substantially flat, while in the first configuration the laminar element itself is deformed to take a substantially curved shape.

The possibility cannot be ruled out of providing an alternative embodiment not shown in the illustrations in which the laminar element 12 in the first configuration is substantially flat, whereas in the second configuration it is deformed to take the substantially curved shape.

As shown in the illustrations, the dispensing element 13 extends along at least one main direction A substantially perpendicular to at least one main plane A-A defined by the laminar element 12 in the second configuration and provided with at least one proximal portion 13b associated with the first face 14 of the laminar element 12 and at least one distal portion 13a defining the thrust portion 19.

The possibility of providing the dispensing element 13 with a different shape with respect to that described cannot however be ruled out.

Always as shown in the illustrations, the laminar element 12 in the first configuration is substantially convex and protruding from the main plane A-A from the side of the second chamber 9, although the possibility cannot be ruled out of making the laminar element 12 so that, in at least one of the described configurations, it is substantially convex and protruding from the main plane A-A from the side of the first chamber 3.

During the deformation of the dispensing assembly 12, 13, the dispensing element 13 being entrained in translation along the main direction A due to the deformation of the laminar element 12 in the first configuration, moving the thrust portion away from the dispensing opening 5.

During printing operations, the dispensing assembly 12, 13 is deformed exclusively according to the print indications provided by the digital model.

Usefully, at the points where the deposition of molten metal 4 is not provided and during the appliance stoppage phase, the dispensing assembly 12, 13 is kept in a home configuration wherein the thrust portion 19 is arranged to close the dispensing opening 5, in abutment, so as not to risk the accidental dispensing of the molten metal 4.

Advantageously, the movement of the laminar element 12 from the first configuration to the second configuration, and vice versa, is of a substantially periodic type, inasmuch as the pressure variation means 11 are adapted to vary the pressure in the second chamber 9 substantially periodically at a predetermined frequency.

The periodic movement of the laminar element 12 permits dispensing the molten metal 4 through the dispensing opening 5 in small drops 17, which are deposited on the appropriate support 6 following a predetermined three-dimensional digital design, so as to form the desired object.

Usefully, the dispensing opening 5 has a cross section with transverse width 18 comprised between 1 µm and 50 µm, so as to deposit some drops 17 of molten metal 4 having a very small diameter which allow guaranteeing high accuracy in making the three-dimensional object.

In particular, the transverse width 18 is comprised between 10 µm and 30 µm. In the preferred embodiment, the transverse width 18 is equal to 20 µm, although the possibility of providing the transverse width 18 with a different value cannot be ruled out.

Preferably, the cross section of the dispensing opening 5 has a substantially circular shape which, being without edges, allows minimizing friction due to the crossing of the molten metal 4 and, in this case, the transverse width 18 corresponds to the diameter of the cross section itself, although the possibility of making the dispensing opening 5 with a different shape cannot be ruled out.

It has in practice been found that the described invention achieves the intended objects.

In this regard, the fact is underlined that the particular solution of providing a head for the three-dimensional printing of molten metal as described makes it possible to significantly simplify the construction structure of the head itself compared to heads of known type.

Consequently, the simplicity of the construction of the head allows considerably simplifying the operations of making a three-dimensional object made of metal. Furthermore, the particular solution of providing the head for three-dimensional printing with a simple conformation permits reducing the incidence of failures compared to the heads of known type and, consequently, also associated special maintenance costs.

Furthermore, the particular solution of providing a head for three-dimensional printing with a simplified structure makes it possible to streamline the disassembly and assembly operations necessary for routine maintenance, with a reduction in both machine downtimes and related costs.

Again, the particular solution of providing for the head body made by welding two parts in order to form a single body piece within which the dispensing assembly is welded makes it possible to avoid the need to provide for sealing means, which are substantially incompatible with high operating temperatures. Furthermore, the particular solution of providing a dispensing opening with extremely small transverse width permits dispensing a very small amount of molten metal and obtaining a high-definition and accurate three-dimensional object.

## Claims

1. Head (1) for the three-dimensional printing of molten metal comprising at least one hollow body (2) comprising:
- at least a first chamber (3) adapted to contain at least one molten metal (4) in which at least one dispensing opening (5) is formed for the dispensing of said molten metal (4);
- at least a second chamber (9) adapted to contain at least one operating fluid (10) and connected to pressure variation means (11) adapted to define a pressure difference between said first chamber (3) and said second chamber (9); and
- at least one dispensing assembly (12, 13) comprising at least one flexible laminar element (12) separating said first chamber (3) and said second chamber (9), said laminar element (12) being deformable by means of a pressure variation in said second chamber (9) and the deformation of said laminar element (12) thus determining the outflow of said molten metal (4) from said dispensing opening (5);
**characterized by** the fact that said dispensing assembly (12, 13) comprises at least one dispensing element (13) housed in said first chamber (3), associated with said laminar element (12) and comprising at least one thrust portion (19) dipped in said molten metal (4) and arranged in the proximity of said dispensing opening (5), the deformation of said laminar element (12) occurring between a first configuration in which said thrust portion (19) is arranged away from said dispensing opening (5) and a second configuration in which said thrust portion (19) is approached to said dispensing opening (5), in which the approach of said thrust portion (19) to said dispensing opening (5) determines the outflow of said molten metal (4) from said dispensing opening (5).

2. Head (1) according to claim 1, wherein said laminar element (12) comprises at least a first face (14) facing said first chamber (3) and at least a second face (15) opposite said first face (14) and facing said second chamber (9) and is peripherally associated in an irremovable manner with at least one lateral wall (16) of said body (2) by means of welding means, said first chamber (3) and said second chamber (9) being insulated from each other in a fluid-operated manner.

3. Head (1) according to one or more of the preceding claims, wherein the movement of said laminar element (12) between said first configuration and said second configuration is of a periodic type, said pressure variation means (11) being adapted to vary said pressure in said second chamber (9) periodically at a predetermined frequency.

4. Head (1) according to one or more of the preceding claims, wherein in said second configuration said laminar element (12) is flat and in said first configuration said laminar element (12) is deformed to take a curved shape.

5. Head (1) according to one or more of the preceding claims, wherein said dispensing element (13) extends along at least one main direction (A) perpendicular to at least one main plane (A-A) defined by said laminar element (12) in said second configuration and provided with at least one proximal portion (13b) associated with said first face (14) and at least one distal portion (13a) defining said thrust portion (19).

6. Head (1) according to one or more of the preceding claims, wherein said laminar element (12) in said first configuration is convex and protruding from said main plane (A-A) from the side of said second chamber (9), said dispensing element (13) being entrained in translation along said main direction (A) due to the deformation of said laminar element (12) in said first configuration.

7. Head (1) according to one or more of the preceding claims, wherein said first chamber (3) is provided with heating means adapted to maintain the temperature of said molten metal (4) equal to a predetermined value.

8. Head (1) according to one or more of the preceding claims, wherein said first chamber (3) contains inert atmosphere (8).

9. Head (1) according to one or more of the preceding claims, wherein said dispensing opening (5) has a cross section with transverse width (18) comprised between 1 µm and 50 µm.

10. Head (1) according to claim 9, wherein said transverse width (18) is between 10 µm and 30 µm.

11. Head (1) according to claim 9, wherein said transverse width (18) is equal to 20 µm.

## Patentansprüche

1. Kopf (1) für das dreidimensionale Drucken von geschmolzenem Metall mit mindestens einem Hohlkörper (2), umfassend
- mindestens eine erste Kammer (3), welche dazu ausgelegt ist, mindestens eine Metallschmelze (4) zu enthalten und in welcher mindestens eine Abgabeöffnung (5) für die Abgabe der Metallschmelze (4) ausgebildet ist;
- mindestens eine zweite Kammer (9), welche dazu ausgelegt ist, mindestens ein Betriebsfluid (10) zu enthalten und welche mit Druckänderungsmitteln (11) verbunden ist, welche geeignet sind, eine Druckdifferenz zwischen der ersten Kammer (3) und der zweiten Kammer (9) zu definieren; und
- mindestens eine Abgabeanordnung (12, 13), welche mindestens ein flexibles Lamellenelement (12) umfasst, welches die erste Kammer (3) und die zweite Kammer (9) trennt, wobei das Lamellenelement (12) durch eine Druckänderung in der zweiten Kammer (9) verformbar ist und die Verformung des Lamellenelements (12) somit den Ausfluss der Metallschmelze (4) aus der Abgabeöffnung (5) bestimmt;
**dadurch gekennzeichnet, dass** die Abgabeanordnung (12, 13) mindestens ein Abgabeelement (13) umfasst, welches in der ersten Kammer (3) untergebracht ist, mit dem Lamellenelement (12) verbunden ist und mindestens einen Druckabschnitt (19) umfasst, welcher in die Metallschmelze (4) getaucht und in der Nähe der Abgabeöffnung (5) angeordnet ist, wobei die Verformung des Lamellenelements (12) zwischen einer ersten Konfiguration, in welcher der Druckabschnitt (19) von der Abgabeöffnung (5) entfernt angeordnet ist, und einer zweiten Konfiguration, in welcher sich der Druckabschnitt (19) näher an der Abgabeöffnung (5) befindet, erfolgt, wobei die Annäherung des Druckabschnitts (19) an die Abgabeöffnung (5) den Ausfluss der Metallschmelze (4) aus der Abgabeöffnung (5) bestimmt.

2. Kopf (1) nach Anspruch 1, wobei das Lamellenelement (12) mindestens eine erste Fläche (14), welche der ersten Kammer (3) zugewandt ist, und mindestens eine zweite Fläche (15), welche der ersten Fläche (14) gegenüberliegt und der zweiten Kammer (9) zugewandt ist, aufweist und am Umfang mit mindestens einer Seitenwand (16) des Körpers (2) mittels Schweißmitteln unlösbar verbunden ist, wobei die erste Kammer (3) und die zweite Kammer (9) fluidtechnisch voneinander isoliert sind.

3. Kopf (1) nach einem oder mehreren der vorhergehenden Ansprüche, wobei die Bewegung des Lamellenelements (12) zwischen der ersten Konfiguration und der zweiten Konfiguration periodisch erfolgt, wobei das Druckveränderungsmittel (11) so beschaffen ist, dass es den Druck in der zweiten Kammer (9) periodisch mit einer vorgegebenen Frequenz verändert.

4. Kopf (1) nach einem oder mehreren der vorhergehenden Ansprüche, wobei in der zweiten Konfiguration das Lamellenelement (12) flach ist und in der ersten Konfiguration das Lamellenelement (12) verformt ist, um eine gekrümmte Form anzunehmen.

5. Kopf (1) nach einem oder mehreren der vorhergehenden Ansprüche, wobei sich das Abgabeelement (13) entlang mindestens einer Hauptrichtung (A) senkrecht zu mindestens einer Hauptebene (A-A) erstreckt, welche durch das Lamellenelement (12) in der zweiten Konfiguration definiert ist, und mit mindestens einem proximalen Abschnitt (13b), welcher mit der ersten Fläche (14) verbunden ist, und mindestens einem distalen Abschnitt (13a) versehen ist, welcher den Druckabschnitt (19) definiert.

6. Kopf (1) nach einem oder mehreren der vorhergehenden Ansprüche, wobei das Lamellenelement (12) in der ersten Konfiguration konvex ist und von der Hauptebene (A-A) von der Seite der zweiten Kammer (9) vorsteht, wobei das Abgabeelement (13) aufgrund der Verformung des Lamellenelements (12) in der ersten Konfiguration entlang der Hauptrichtung (A) in eine Translationsbewegung versetzt wird.

7. Kopf (1) nach einem oder mehreren der vorhergehenden Ansprüche, wobei die erste Kammer (3) mit Heizmitteln versehen ist, welche so beschaffen sind, dass sie die Temperatur der Metallschmelze (4) auf einem vorgegebenen Wert halten.

8. Kopf (1) nach einem oder mehreren der vorhergehenden Ansprüche, wobei die erste Kammer (3) eine inerte Atmosphäre (8) enthält.

9. Kopf (1) nach einem oder mehreren der vorhergehenden Ansprüche, wobei die Abgabeöffnung (5) einen Querschnitt mit einer Querbreite (18) zwischen 1 µm und 50 µm aufweist.

10. Kopf (1) nach Anspruch 9, wobei die Querbreite (18) zwischen 10 µm und 30 µm beträgt.

11. Kopf (1) nach Anspruch 9, **dadurch gekennzeichnet, dass** die Querbreite (18) gleich 20 µm ist.

## Revendications

1. Tête (1) pour l'impression en trois dimensions de métal en fusion comprenant au moins un corps (2) creux comprenant :
- au moins une première chambre (3) adaptée pour contenir au moins un métal en fusion (4), dans laquelle au moins une ouverture de distribution (5) est formée pour la distribution dudit métal en fusion (4) ;
- au moins une deuxième chambre (9) adaptée pour contenir au moins un fluide actif (10) et connectée à des moyens de variation de pression (11) adaptés pour définir une différence de pression entre ladite première chambre (3) et ladite deuxième chambre (9) ; et
- au moins un ensemble de distribution (12, 13) comprenant au moins un élément laminaire (12) flexible séparant ladite première chambre (3) et ladite deuxième chambre (9), ledit élément laminaire (12) étant déformable au moyen d'une variation de pression dans ladite deuxième chambre (9), et la déformation dudit élément laminaire (12) déterminant ainsi l'écoulement à la sortie dudit métal en fusion (4) depuis ladite ouverture de distribution (5) ;
**caractérisée par le fait que** ledit ensemble de distribution (12, 13) comprend au moins un élément de distribution (13) logé dans ladite première chambre (3), associé audit élément laminaire (12) et comprenant au moins une partie de poussée (19) plongée dans ledit métal en fusion (4) et agencée à proximité de ladite ouverture de distribution (5), la déformation dudit élément laminaire (12) se produisant entre une première configuration, dans laquelle ladite partie de poussée (19) est agencée à l'écart de ladite ouverture de distribution (5), et une deuxième configuration dans laquelle ladite partie de poussée (19) est approchée de ladite ouverture de distribution (5), dans laquelle l'approche de ladite partie de poussée (19) de ladite ouverture de distribution (5) détermine l'écoulement à la sortie dudit métal en fusion (4) depuis ladite ouverture de distribution (5).

2. Tête (1) selon la revendication 1, dans laquelle ledit élément laminaire (12) comprend au moins une première face (14) tournée vers ladite première chambre (3) et au moins une deuxième face (15) opposée à ladite première face (14) et tournée vers ladite deuxième chambre (9), et est associé sur la périphérie de manière inamovible à au moins une paroi latérale (16) dudit corps (2) par des moyens de soudage, ladite première chambre (3) et ladite deuxième chambre (9) étant isolées l'une de l'autre de manière actionnée par fluide.

3. Tête (1) selon une ou plusieurs des revendications précédentes, dans laquelle le déplacement dudit élément laminaire (12) entre ladite première configuration et ladite deuxième configuration est de type périodique, lesdits moyens de variation de pression (11) étant adaptés pour faire varier ladite pression dans ladite deuxième chambre (9) périodiquement à une fréquence prédéterminée.

4. Tête (1) selon une ou plusieurs des revendications précédentes, dans laquelle, dans ladite deuxième configuration, ledit élément laminaire (12) est plat, et dans ladite première configuration, ledit élément laminaire (12) est déformé pour prendre une forme courbe.

5. Tête (1) selon une ou plusieurs des revendications précédentes, dans laquelle ledit élément de distribution (13) s'étend le long d'au moins une direction principale (A) perpendiculaire à au moins un plan principal (A-A) défini par ledit élément laminaire (12) dans ladite deuxième configuration et pourvu d'au moins une partie proximale (13b) associée à ladite première face (14) et d'au moins une partie distale (13a) définissant ladite partie de poussée (19).

6. Tête (1) selon une ou plusieurs des revendications précédentes, dans laquelle ledit élément laminaire (12) dans ladite première configuration est convexe et fait saillie depuis ledit plan principal (A-A) à partir du côté de ladite deuxième chambre (9), ledit élément de distribution (13) étant entraîné en translation le long de ladite direction principale (A) du fait de la déformation dudit élément laminaire (12) dans ladite première configuration.

7. Tête (1) selon une ou plusieurs des revendications précédentes, dans laquelle ladite première chambre (3) est pourvue de moyens de chauffage adaptés pour maintenir la température dudit métal en fusion (4) égale à une valeur prédéterminée.

8. Tête (1) selon une ou plusieurs des revendications précédentes, dans laquelle ladite première chambre (3) contient une atmosphère inerte (8).

9. Tête (1) selon une ou plusieurs des revendications précédentes, dans laquelle ladite ouverture de distribution (5) a une section transversale de largeur transversale (18) comprise entre 1 µm et 50 µm.

10. Tête (1) selon la revendication 9, dans laquelle ladite largeur transversale (18) est entre 10 µm et 30 µm.

11. Tête (1) selon la revendication 9, dans laquelle ladite largeur transversale (18) est égale à 20 µm.
